# EUROPEAN PATENT APPLICATION

(11) **EP 1 873 694 A1**
(43) Date of publication of application: **02.01.2008**
(21) Application number: 07100034.3
(22) Date of filing: 02.01.2007
(51) Int. Cl.: G06K 19/077, H01Q 1/38, H01Q 7/00

(54) **RFID tag manufacturing method and RFID tag**

(30) Priority: 30.06.2006 JP 2006181814
(71) Applicant: Fujitsu Ltd., Kawasaki-shi, Kanagawa 211-8588 (JP)
(72) Inventor: Kobayashi, Hiroshi c/o Fujitsu Limited,, Kawasaki-shi, Kanagawa 211-8588 (JP); Ishikawa, Naoki c/o Fujitsu Limited,, Kawasaki-shi, Kanagawa 211-8588 (JP); Matsumura, Takayoshi c/o Fujitsu Limited,, Kawasaki-shi, Kanagawa 211-8588 (JP)
(74) Representative: Cooper-Rolfe, Elizabeth Louise

(57) **Abstract**

An RFID tag manufacturing method manufactures an RFID tag which has flattened surfaces and serves as a metal tag. The method includes a surface-layer-forming step of forming a surface layer having a predetermined thickness on a base plate on which a metal antenna pattern is formed and a mounting step for mounting a circuit chip on the base plate such that the circuit chip is connected to the both ends of the metal antenna pattern.

## Description

### BACKGROUND OF THE INVENTION

### Field of the Invention

The present invention relates to an RFID (Radio_Frequency_ IDentification) tag which exchanges information with an external device without contacting the device. Among people skilled in the field of the art, an "RFID tag" used in the invention is also called as an "inlay for RFID tag", an inlay which is an internal component of an "RFID tag". Or, this "RFID tag" is also called as a "wireless IC tag". The RFID tag includes a noncontact IC card.

### Description of the Related Art

In recent years, various RFID tags have been proposed. They exchange information with an external device typified by a reader and a writer using a radio wave without contacting the device. Various kinds of the RFID tags are introduced including the one that an antenna pattern and an IC chip are mounted on a base sheet made of a plastic and a paper (for example, see Japanese Patent Application Publication Nos. 2000-311226, 2000-200332 and 2001-351082). For these types of RFID tags, an application such as discriminating of an article and the like with the RFID tag attached by exchanging information about the article and the like with an external device is devised.

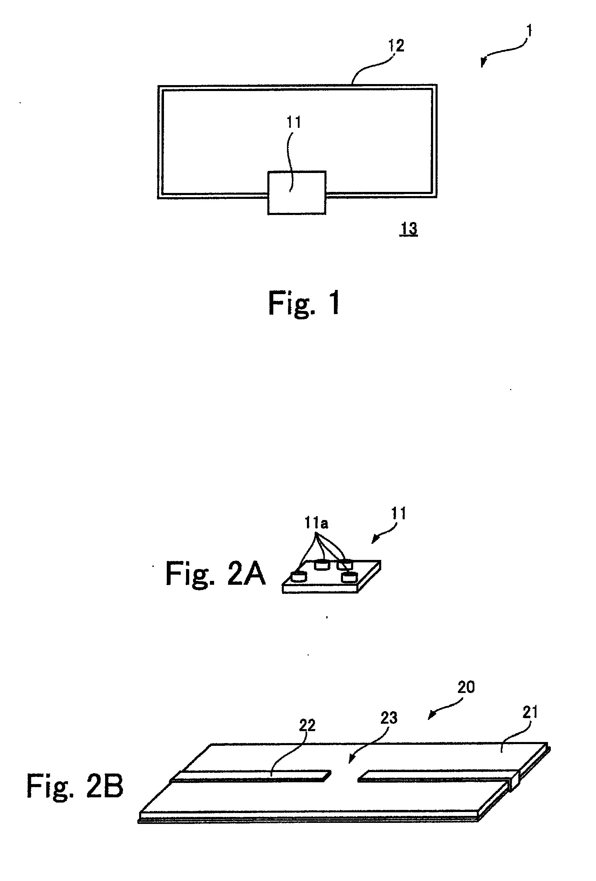

Fig. 1 is a plan view showing an example of an RFID tag.

An RFID tag 1 shown in Fig. 1 includes an antenna 12 arranged on a base 13 made of a sheet of a PET film and others and an IC chip 11 which is electrically connected to the antenna 12 with gold, solder or the like and which is fixed on the base 13 with an adhesive agent.

The IC chip 11 constituting the RFID tag 1 performs radio communication with an external device through the antenna 12 to exchange information with the device.

In Fig. 1, the antenna 12 is shown as a loop antenna. However, the antenna 12 is not limited to a loop in shape. Other types of antennas such as a pair of straight lines which extend in different directions each other away from the IC 11 with the IC 11 placed in the center between the lines can be applied.

The RFID tag described above may be seriously deteriorated in communication performance due to the presence of an external metal chip and the like near the RFID tag. An RFID tag called a "metal tag" is known for preventing this deterioration. The metal tag has a structure in which a base plate is surrounded with a metal pattern which works as an antenna. Even when a metal chip and the like come near the RFID tag, the metal tag can perform communication with a part of the metal pattern excluding an area of the metal tag shadowed by the metal chip.

An existing manufacturing method of a metal tag will be described as follows.

Figs. 2A and 2B are perspective views of parts used for manufacturing a metal tag.

In the Figs. 2A and 2B, the IC chip 11 (Fig. 2A) and a base plate 20 for the metal tag (Fig. 2B) are prepared.

As shown in Fig. 2A, bumps 11a made of gold and the like are formed on connecting terminals in the IC chip 11. In Fig. 2A, the IC chip 11 is shown upside down in Fig. 1 so that a surface with the bumps 11a forward thereon can be seen. The IC chip 11 performs communication with an external device through an antenna (which will be described later) to exchange information with the external device (see Fig. 1).

In the base plate 20, a metal antenna pattern 22, which works as an antenna after assembled, is formed on a dielectric plate 21 excluding a mount area 23 where an IC chip is mounted.

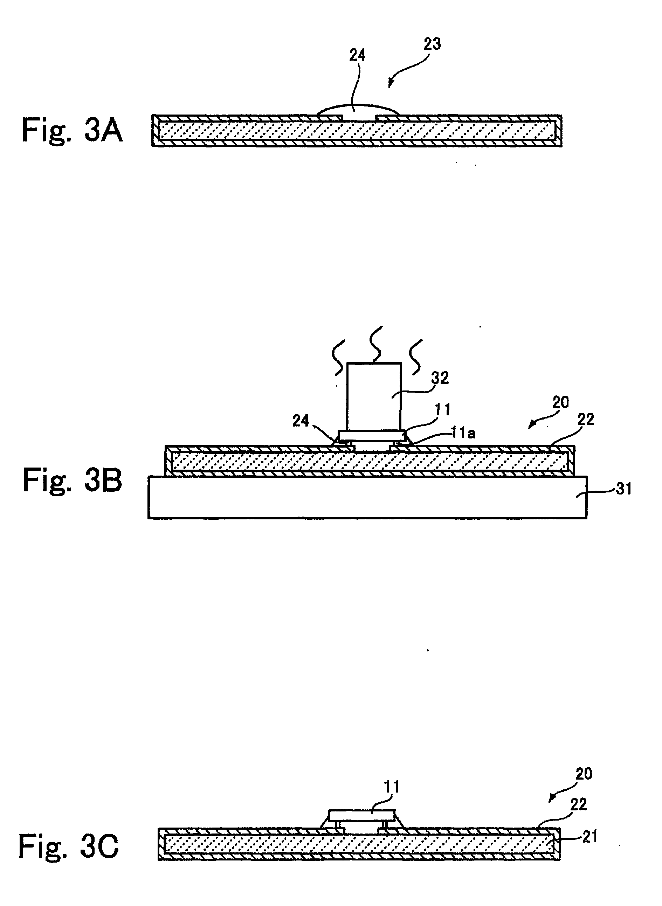

Figs. 3A, 3B and 3C are process charts showing an example of a manufacturing method of the metal tag.

A liquid or a sheet of a under fill material 24, which is a thermosetting adhesive agent, is applied in the mount area 23 where the IC chip is mounted on the base plate 20 (Fig. 3A) . The IC chip 11 is placed in the mount area 23. Then a heating stage 31 and a heating head 32 sandwich the base plate 20 and the IC chip 11 to be heated and pressed. Consequently, the IC chip 11 is electrically connected to the metal antenna pattern 22 through the bumps 11a and is simultaneously fixed on the base plate 20 as the under fill material 24 cures (Fig. 3B).

Through this process, an RFID tag with a structure shown in Fig. 3C is manufactured.

In this RFID tag, the IC chip 11 performs radio communication with an external device through the metal antenna pattern 22 which is formed on the dielectric plate 21 surrounding the top and the bottom surfaces of the dielectric plate 21 and works as a loop antenna.

This type of RFID tag is a so-called metal tag, and can perform communication through its top surface of the base plate 20 on which surface the IC chip 11 is mounted even if an external metal chip comes near its bottom surface of the base plate 20.

Here, considering such an application that an RFID tag is attached to an article, it is desirable that surfaces of the RFID tag are flat. However, it is difficult to flatten the surfaces of the RFID tag manufactured through the manufacturing method described above referring to Figs. 2A, 2B and Figs. 3A, 3B and 3C because the IC chip mounted on the base plate 20 is projected from the top surface of the base plate 20.

### SUMMARY OF THE INVENTION

In the view of foregoing, the present invention provides a manufacturing method for an RFID tag which has flattened surfaces and performs as a metal tag, and an RFID tag manufactured through the manufacturing method.

According to the invention, there is provided the RFID tag manufacturing method including:
a surface-layer-forming step for forming a surface layer having a predetermined thickness on a first surface which is one of a top and a bottom surfaces of a base plate, excluding a mount area of the base plate, the base plate formed by extending a metal antenna pattern to a first surface that is one of a top and a bottom surfaces of a tabular base and to a second surface opposite to the first surface to surround the tabular base and have both ends thereof on the first surface, so that the metal antenna pattern works as an antenna after assembled, the mount area where a circuit chip is mounted on the first surface to be connected with the both ends of the metal antenna pattern, thereby performing radio communication through the metal antenna pattern; and
a mounting step for mounting the circuit chip on the first surface of the base plate such that the circuit chip is connected with the both ends of the metal antenna pattern.

According to the RFID tag manufacturing method of the invention, an RFID tag, which is surrounded by the surface layer around the circuit chip on the base plate and has performance as a "metal tag", is manufactured. For example, when the surface layer is formed in an almost same thickness as a projection level of the circuit chip from the surface of the base plate, a top surface of the circuit chip and a surface of the surface layer are in almost same level so that a surface of the finished RFID is almost flattened. In other words, according to the RFID tag manufacturing method of the invention, an RFID tag which has a flattened surface and has performance as a metal tag is obtained.

In the RFID tag manufacturing method according to the invention, an example of the surface-layer-forming step may be performed before the mounting step, or another example may be performed after the mounting step.

In the former example, the surface-layer-forming step is readily performed because it is done without a mounted item on the base plate. In the latter example, the surface of the base plate is flattened still certainly because the surface-layer-forming step is performed through checking a projection level of the circuit chip mounted on the base plate.

In an example of the RFID tag manufacturing method according to the invention, the mounting step may be connecting the circuit chip to the both ends of the metal antenna pattern and fixing the circuit chip on the base plate by heating and pressing the circuit chip and the base plate after applying a thermosetting adhesive agent in the mount area of the base plate to mount the circuit chip in the mount area.

According to this example, the mounting step may be efficiently performed.

In addition, according to the invention, there is provided an RFID tag including:
a base plate in which a metal antenna pattern is formed by extending a metal antenna pattern to a first surface that is one of a top and a bottom surfaces of a tabular base and to a second surface opposite to the first surface to surround the tabular base and have both ends thereof on the first surface so that the metal antenna pattern works as an antenna after assembled;
a circuit chip which is mounted on the base plate and connected with the both ends of the metal antenna pattern thereby performing radio communication through the metal antenna pattern; and
a surface layer which is formed in a predetermined thickness of the first surface of the base plate, excluding a mount area for the circuit chip.

In the RFID tag according to the invention, for example, when the surface layer is formed in an almost same thickness as a projection level of the circuit chip from a surface of the base plate, the RFID tag has an almost flattened surface where the top surface of the circuit chip and the surface of the surface layer described above are in an almost same level.

As described above, according to the invention, an RFID tag which has a flattened surface and has performance as a metal tag is obtained.

### BRIEF DESCRIPTION OF THE DRAWINGS

Fig. 1 is a plan view showing an RFID tag.
Figs. 2A and 2B are perspective views of parts used for manufacturing a metal tag.
Figs. 3A, 3B and 3C are process charts of a manufacturing method of a metal tag.
Figs. 4A, 4B and 4C are perspective views of parts commonly used for both a first RFID tag manufacturing method as a first embodiment and a second RFID tag manufacturing method as a second embodiment according to the invention.
Figs. 5A, 5B, 5C and 5D are process charts of the first RFID tag manufacturing method as the first embodiment according to the invention.
Figs. 6A, 6B, 6C and 6D are process charts of the second RFID tag manufacturing method as the second embodiment according to the invention.

### DETAILED DESCRIPTION OF THE INVENTION

Exemplary embodiments according to the invention will be described with reference to the attached drawings.

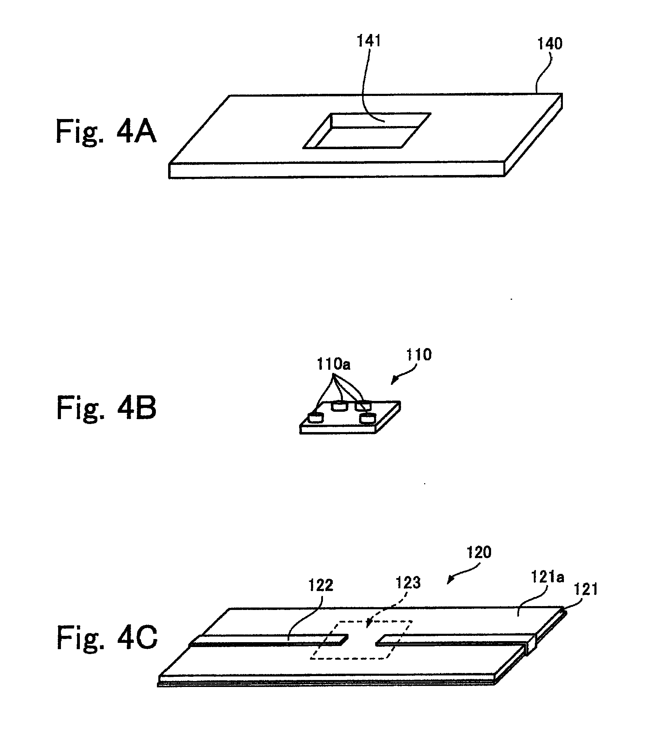

Figs. 4A, 4B and 4C are perspective views of parts commonly used for both the first manufacturing method as the first embodiment of the RFID tag manufacturing method and the second manufacturing method as the second embodiment of the RFID tag manufacturing method according to the invention.

A PET sheet 140 shown in Fig. 4A, an IC chip 110 shown in Fig. 4B and a base plate 120 shown in Fig. 4C are prepared in these two manufacturing methods.

The PET sheet 140 shown in Fig. 4A is provided with an opening 141 in its center portion, and is applied with an adhesive agent on a bottom face which contacts the base plate 120 in manufacturing. The PET sheet 140 has a thickness close to a projection level of the IC chip 110 from the surface of the base plate 120 when the IC chip 110 is mounted on the base plate 120. The PET sheet 140 is glued to the base plate 120, which will be described later, to serve as an example of the surface layer according to the invention.

The IC chip 110 shown in Fig. 4B is similar to the IC chip 11 shown in Fig. 2A described above, and performs communication with an external device through an antenna, which will be described later, to exchange information. Bumps 110a are formed on connecting terminals. In Fig. 4A similarly to in Fig. 2A, the IC chip 110 is depicted in such a manner that a surface with the bumps 11a formed on can be seen. The IC chip 110 corresponds to an example of the circuit chip according to the invention.

The base plate 120 shown in Fig. 4C is similar to the base plate 20 shown in Fig. 2B described above. A metal antenna pattern 122, which works as an antenna after assembled, is formed about a dielectric plate 121 by surrounding the base plate 120 in such a manner that its both ends is positioned in a mount area 123 for the IC chip 110. The base plate 120, the metal antenna pattern 122 and the mount area 123 respectively correspond to examples of the base plate, the metal antenna pattern and the mount area according to the invention. In the top and bottom surfaces of the base plate 120, the top surface 121a including the mount area 123 corresponds to an example of the first surface according to the invention, and the bottom surface on the other side of the base plate 120 corresponds to an example of the second surface according to the invention.

Next, the first manufacturing method as the first embodiment of the RFID manufacturing method according to the invention will be described. The first manufacturing method is performed using the parts shown in Figs. 4A, 4B and 4C.

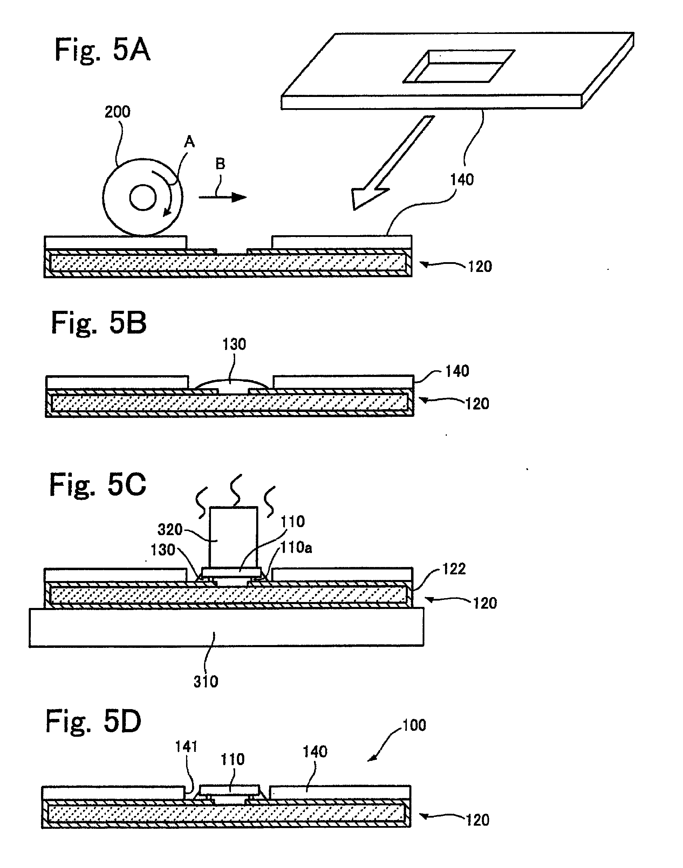

Figs. 5A, 5B, 5C and 5D are process charts showing the first manufacturing method as the first embodiment of the RFID tag manufacturing method according to the invention.

An adhering process where the PET sheet 140 is glued to the top surface 121a of the base plate 120 (see Fig. 4C) is shown in Fig. 5A. This process shown in Fig. 5A corresponds to an example of the surface-layer-forming of the RFID tag manufacturing method according to the invention. In the process shown in Fig. 5A, first, the PET sheet 140 is set on the base plate 120 such that a bottom surface applied with an adhesive agent of the PET sheet 140 touches the top surface 121a of the base plate 120 (see Fig. 4C). Then, the PET sheet 140 is pressed on the base plate 120 through rolling a roller 200 in directions indicated by arrows A and B on the surface of the PET sheet 140. Accordingly, the PET sheet 140 is pressed and glued to the base plate 120. Through the process described above, an example of the surface layer according to the invention is formed on the surface 121a of the base plate 120 (see Fig. 4C).

In a process shown in Fig. 5B, a liquid or a sheet of a under fill material 130, which is a thermosetting adhesive agent, is applied in the mount area 123 of on the base plate 120 (see Fig. 4C). In a subsequent process shown in Fig. 5C, the IC chip 110 is placed in the mount area 123 (refer to Fig. 4C). Then a heating stage 310 and a heating head 320 sandwich the base plate 120 and the IC chip 110 to heat and press them. Consequently, the IC chip 110 is electrically connected to a metal antenna pattern 122 through the bumps 110a and is simultaneously fixed on the base plate 120 as the under fill material 130 cures. A combination of the processes shown in Figs. 5B and 5C corresponds to an example of the mounting step of the RFID tag manufacturing method according to the invention.

Through the processes described above, an RFID tag 100 with a structure shown in a cross section of Fig. 5D is manufactured. The RFID tag 100 corresponds to an example of the RFID tag according to the invention. The RFID tag 100 is a so-called metal tag and has desirable communication performance even in such a case where a metal chip or the like comes near the bottom surface opposite to the surface mounted with the IC chip 110.

In addition, in the RFID tag 100, the top surface of the IC chip 110 and the surface opposite to the glued surface of the PET sheet 140 are in the almost same level. Accordingly, the surfaces of the RFID tag 100 are almost flattened.

Thus, according to the first manufacturing method shown in Fig. 5A, 5B, 5C and 5D, the RFID tag, which is flattened and simultaneously has performance as a metal tag, is obtained.

Next, the second manufacturing method as the second embodiment of the RFID tag manufacturing method according to the invention will be described. The second manufacturing method is performed using the parts shown in Figs. 4A, 4B and 4C.

The second manufacturing method is different from the first manufacturing method shown in Figs. 5A, 5B, 5C and 5D in that the above-mentioned process in which the PET sheet 140 is glued to the base plate 120 is performed after the process in which IC chip 110 is mounted. The second manufacturing method will be described paying attention to the differences.

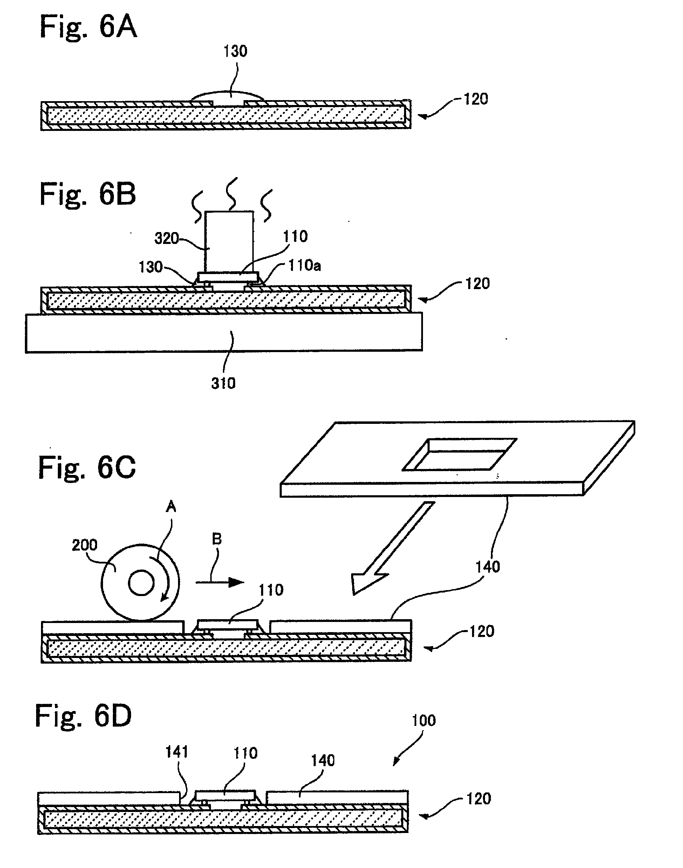

Figs. 6A, 6B, 6C and 6D are process charts of the second manufacturing method as the second embodiment of the RFID tag manufacturing method according to the invention.

In a process shown in Fig. 6A, the under fill 130 is applied in the mount area 123 of the base plate 120 (see Fig. 4C) before the PET sheet 140 is glued. In a process shown in Fig. 6B, the heating stage 310 and the heating head 320 heat and press the IC chip 110 and the base plate 120 to fix the IC chip 110 on the base plate 120. A combination of the process shown in Fig. 6A and the process shown in Fig. 5B corresponds to an example of the mounting step of the RFID tag manufacturing method according to the invention.

In a process shown in Fig. 6C, the PET sheet 140 is glued to the base plate 120, on which the IC chip 110 is already fixed, through moving rotationally the roller 200 (in the directions indicated by the arrows A and B) . As described above, because the PET sheet 140 has a thickness close to a projection level of the IC chip 110 from the surface of the base plate, the IC chip 110 does not interfere the rotational movement of the roller 200 to glue the PET sheet 140 to the base plate. The process shown in Fig. 6C corresponds to an example of the surface-layer-forming step of the RFID tag manufacturing method according to the invention.

Through the processes described above, the RFID tag 100, which has the same structure shown in a cross section of Fig. 6D as the one shown in Fig. 5D, is manufactured. Through the second manufacturing method shown in Figs. 6A, 6B, 6C and 6D as well as the first manufacturing method shown in Figs. 5A, 5B, 5C and 5D, the RFID tag 100, which is flattened and simultaneously has performance as a metal tag, is obtained.

In the above description, the process in which the surface layer is formed through adhering the PET sheet on the base plate is exemplified as the surface-layer-forming step according to the invention. However, the invention is not limited to this. The surface-layer-forming step according to the invention may take the following processes. For example, for forming the surface layer, a sheet of paper having almost same thickness as a projection level of an IC chip from a surface of a base plate may be glued to the base plate to form the surface layer, or a resist material is applied on the base plate, in an almost same thickness as a projection level of an IC chip. The sheet of paper glued to the base plate in the former example and the resist material applied on the base plate in the latter example correspond to examples of the surface layer according to the invention.

## Claims

1. An RFID tag manufacturing method comprising:
a surface-layer-forming step for forming a surface layer having a predetermined thickness on a first surface which is one of a top and a bottom surfaces of a base plate, excluding a mount area of the base plate, the base plate formed by extending a metal antenna pattern to a first surface that is one of a top and a bottom surfaces of a tabular base and to a second surface opposite to the first surface to surround the tabular base and have both ends thereof on the first surface, so that the metal antenna pattern works as an antenna after assembled, the mount area where a circuit chip is mounted on the first surface to be connected with the both ends of the metal antenna pattern, thereby performing radio communication through the metal antenna pattern; and
a mounting step for mounting the circuit chip on the first surface of the base plate such that the circuit chip is connected with the both ends of the metal antenna pattern.

2. The RFID tag manufacturing method according to claim 1, wherein the surface-layer-forming step is performed before the mounting step.

3. The RFID tag manufacturing method according to claim 1, wherein the surface-layer-forming step is performed after the mounting step.

4. The RFID tag manufacturing method according to claim 1, 2 or 3, wherein the mounting step further comprising:
an applying step for applying a thermosetting adhesive agent in the mount area of the base plate to mount the circuit chip in the mount area; and
a connecting step for connecting the circuit chip to the both ends of the metal antenna pattern to fix the circuit chip on the base plate by heating and pressing the circuit chip and the base plate.

5. An RFID tag comprising:
a base plate in which a metal antenna pattern is formed by extending a metal antenna pattern to a first surface that is one of a top and a bottom surfaces of a tabular base and to a second surface opposite to the first surface to surround the tabular base and have both ends thereof on the first surface so that the metal antenna pattern works as an antenna after assembled;
a circuit chip which is mounted on the base plate and connected with the both ends of the metal antenna pattern thereby performing radio communication through the metal antenna pattern; and
a surface layer which is formed in a predetermined thickness of the first surface of the base plate, excluding a mount area for the circuit chip.
